# EUROPEAN PATENT APPLICATION

(11) **EP 2 055 757 A1**
(43) Date of publication of application: **06.05.2009**
(21) Application number: 07792745.7
(22) Date of filing: 20.08.2007
(51) Int. Cl.: C09J 9/02, C09J 5/06, C09J 11/08, C09J 179/08, H01R 11/01, H05K 3/36, H01B 1/00, H01B 1/22

(54) **CIRCUIT CONNECTING MATERIAL, CONNECTION STRUCTURE OF CIRCUIT MEMBER, AND METHOD FOR MANUFACTURING CONNECTION STRUCTURE OF CIRCUIT MEMBER**

(30) Priority: 22.08.2006 JP 2006225290; 25.05.2007 JP 2007139439
(71) Applicant: Hitachi Chemical Company, Ltd., Tokyo 163-0449 (JP)
(72) Inventor: ARIFUKU, Motohiro, Chikusei-shi, Ibaraki 308-8524 (JP); MOCHIZUKI, Nichiomi, Chikusei-shi, Ibaraki 308-8524 (JP); KOBAYASHI, Kouji, Chikusei-shi, Ibaraki 308-8524 (JP); NAKAZAWA, Takashi, Chikusei-shi, Ibaraki 308-8524 (JP); TATSUZAWA, Takashi, Chikusei-shi, Ibaraki 308-8524 (JP); MASUDA, Katsuyuki, Chikusei-shi, Ibaraki 308-8521 (JP); EJIRI, Takako, Chikusei-shi, Ibaraki 308-8521 (JP)
(74) Representative: Jönsson, Hans-Peter
(86) International application number: PCT/JP2007/066132
(87) International publication number: WO 2008/023670

(57) **Abstract**

The present invention provides a circuit connecting material for electrically connecting a first circuit member having a first circuit electrode formed on a major surface of a first circuit substrate, and a second circuit member having a second circuit electrode formed on a major surface of a second circuit substrate, with the first and the second circuit electrodes opposed to each other, comprising an adhesive component containing a fluorine-containing organic compound, wherein the adhesive component contains 0.10% or less by mass of a silicon-containing compound, in terms of silicon atoms, based on the total amount of the adhesive component.

## Description

### Technical Field

The present invention relates to a circuit connecting material, a circuit member connection structure, and a method for manufacturing a circuit member connection structure.

### Background Art

In recent years, various adhesive materials have been used to fix electronic parts and connect circuits in the fields of semiconductors, liquid crystal displays, and the like. In these applications, increasingly higher density and higher definition are achieved, and high adhesion and reliability are required for adhesives as well.

Particularly for the connection of a liquid crystal display and a TCP, the connection of an FPC and a TCP, or the connection of an FPC and a print wiring board, an anisotropic conductive adhesive in which conductive particles are dispersed in an adhesive is used as a circuit connecting material. Also, recently, the so-called flip chip mounting, in which a semiconductor silicon chip is directly mounted face down on a substrate, has been performed, instead of conventional wire bonding, also when a semiconductor silicon chip is mounted on a substrate, and the application of the anisotropic conductive adhesive has been started here as well.

Further, in recent years, in the field of precision electronic equipment, higher density of circuits has been achieved, and the electrode width and electrode spacing have become very narrow. Therefore, under the connection conditions of conventional circuit connecting materials using an epoxy resin type, problems such as the falling off, peeling and positional displacement of wiring occur.

Also, a reduction in connection time is desired for an improvement in production efficiency, and a circuit connecting material that can connect within 10 seconds is demanded. Then, circuit connecting materials for electrical and electronic uses that have excellent low-temperature rapid curing properties and have usable life are developed (see, for example, Patent Documents 1 and 2).
Patent Document 1: WO98/44067
Patent Document 2: WO01/015505

### Disclosure of the Invention

### Problems to be Solved by the Invention

However, the above circuit connecting materials have different adhesive strengths, depending on the materials of the circuit members connected. Particularly, when the circuit substrate is polyethylene terephthalate, a polyimide resin, polyethersulfone, an acrylic resin, or glass, when the surface of the circuit member is coated with a silicone resin, a polyimide resin, or an acrylic resin, or when these resins are attached to the surface of the circuit member, there is a tendency that the adhesive strength decreases. On the other hand, it is known that when the circuit connecting material contains a silicon-containing compound having silicon in the molecule, the adhesiveness to glass is improved. However, when a film-like circuit connecting material containing a silicon-containing compound is used as an adhesive sheet provided on a supporting substrate, the tack to the supporting substrate increases over time. As a result, the transferability of the circuit connecting material from the supporting substrate decreases easily. Then, a circuit connecting material that has excellent adhesiveness, without depending on the materials of the circuit members, with the change in transferability over time suppressed, is desired.

The present invention has been made in view of the above circumstances, and it is an object of the present invention to provide a circuit connecting material that exhibits sufficiently good adhesive strength, without depending on the materials of the circuit members, and has sufficiently excellent transferability, with the change in transferability over time suppressed, a circuit member connection structure using the same, and a method for manufacturing a circuit member connection structure.

### Means for Solving the Problems

The present invention provides a circuit connecting material for electrically connecting a first circuit member having a first circuit electrode formed on a major surface of a first circuit substrate, and a second circuit member having a second circuit electrode formed on a major surface of a second circuit substrate, with the first and the second circuit electrodes opposed to each other, comprising an adhesive component containing a fluorine-containing organic compound, wherein the adhesive component contains 0.10% or less by mass of a silicon-containing compound, in terms of silicon atoms, based on the total amount of the adhesive component.

Also, the present invention provides a circuit connecting material for electrically connecting a first circuit member having a first circuit electrode formed on a major surface of a first circuit substrate, and a second circuit member having a second circuit electrode formed on a major surface of a second circuit substrate, with the first and the second circuit electrodes opposed to each other, comprising an adhesive component containing a fluorine-containing organic compound, wherein the adhesive component contains no silicon-containing compound.

These circuit connecting materials of the present invention exhibit sufficiently good adhesive strength, without depending on the materials of the circuit members, and have sufficiently excellent transferability, with the change in transferability over time suppressed. Factors in obtaining such effect are not presently clarified in detail, but the inventors consider as follows. However, the factors are not limited to this.

As described above, it is known that a silicon-containing compound improves the adhesiveness to glass. However, when a film-like circuit connecting material formed on a supporting substrate contains a silicon-containing compound, the tackiness to the supporting substrate also increases over time. As a result, the circuit connecting material is not easily transferred from the supporting substrate, and the peelability from the supporting substrate decreases. On the other hand, it is known that a fluorine atom has high electronegativity and forms stable compounds with many elements. Also, a fluorine-containing organic compound has excellent compatibility and dispersibility with other components contained in the circuit connecting material. Accordingly, in a circuit connecting material comprising an adhesive component comprising a fluorine-containing organic compound, the adhesive component is uniformly dissolved or dispersed. As a result, it is considered that the circuit connecting material of the present invention has moderate adhesiveness to adherends of various materials. Further, it is known that a fluorine-containing organic compound generally has high surface energy. It is considered that mainly due to this, the circuit connecting material of the present invention has moderate peelability.

In other words, it is presumed that the circuit connecting material according to the present invention exhibits sufficiently good adhesive strength, without depending on the materials of the circuit members, and has sufficiently excellent transferability, with the change in transferability over time suppressed, mainly because the silicon content in the circuit connecting material is limited to 0.1% or less by mass and the circuit connecting material contains a fluorine-containing organic compound as the adhesive component.

In the above circuit connecting material, preferably, the fluorine-containing organic compound has a silicone structure, thereby, obtaining the effect that the adhesiveness, when the circuit substrate is glass or when the surface of the circuit member is coated with a silicone resin, is further improved.

In the circuit connecting material of the present invention, preferably, the adhesive component further contains a radical polymerization initiator, and the fluorine-containing organic compound contains a radically polymerizable fluorine-containing organic compound. Such a circuit connecting material has further excellent adhesiveness, without depending on the materials of the circuit members, and has further excellent transferability, with the change in transferability over time further suppressed.

Further, in the circuit connecting material of the present invention, preferably, the fluorine-containing organic compound contains a fluorine-containing polyimide resin. Such a circuit connecting material further effectively and reliably has excellent adhesiveness and transferability.

In the circuit connecting material of the present invention, preferably, the adhesive component further contains phosphate type (meth)acrylate. Thus, it is possible to further effectively exhibit the effect of the present invention that the circuit connecting material has excellent adhesive strength to various circuit members.

Also, in the circuit connecting material of the present invention, preferably, the adhesive component further contains an epoxy resin curing agent, and the fluorine-containing organic compound contains a fluorine-containing epoxy resin. Such a circuit connecting material exhibits further better adhesive strength, without depending on the materials of the circuit members, and has further excellent transferability, with the change in transferability over time further suppressed.

Also, preferably, the weight average molecular weight of the fluorine-containing organic compound is 5000 or more. Thus, the circuit connecting material has excellent stress relaxation properties during curing, so that it has further excellent adhesiveness and transferability.

In the circuit connecting material of the present invention, preferably, the fluorine-containing organic compound is soluble in an organic solvent. The fluorine-containing organic compound being dissolved in an organic solvent provides a circuit connecting material having more excellent adhesiveness and transferability than the case where the fluorine-containing organic compound is only dispersed in an organic solvent.

Further, preferably, the fluorine-containing organic compound has an aromatic group and/or an alicyclic group. Thus, it is possible to further effectively exhibit the effect of the present invention that the circuit connecting material has excellent adhesive strength to various circuit members, and has excellent transferability, with the change in transferability over time suppressed, and it is possible to improve the heat resistance of the circuit connecting material.

Preferably, the glass transition temperature of the fluorine-containing organic compound is 50°C or more. By containing such a fluorine-containing organic compound, the circuit connecting material of the present invention is easily handled and has further excellent adhesiveness and transferability.

Preferably, the circuit connecting material of the present invention further comprises conductive particles. Thus, the circuit connecting material itself can easily have conductivity. Therefore, this circuit connecting material can be used as a conductive adhesive in the fields of the electric industry and the electronic industry, such as circuit electrodes and semiconductors. Further, in this case, the circuit connecting material has conductivity, so that it is possible to further lower the connection resistance after curing.

The present invention provides a circuit member connection structure comprising: a first circuit member having a first circuit electrode formed on a major surface of a first circuit substrate; a second circuit member having a second circuit electrode formed on a major surface of a second circuit substrate and being located so that the second circuit electrode is located opposed to the first circuit electrode; and a circuit connecting portion provided between the first circuit substrate and the second circuit substrate and connecting the first circuit member and the second circuit member so that the first and the second circuit electrodes are electrically connected, wherein the circuit connecting portion is formed by the cured product of the above-described circuit connecting material.

In such a circuit member connection structure, the circuit connecting portion is formed by the cured product of the circuit connecting material of the present invention having sufficiently excellent adhesiveness and transferability, so that it is possible to reduce the resistance value between the opposed circuit electrodes while maintaining the insulation between the circuit electrodes neighboring on the same circuit member.

In the circuit member connection structure of the present invention, preferably, the surface of at least one of the first and the second circuit electrodes is made of a material comprising at least one selected from the group consisting of gold, silver, tin, platinum group metals, and indium-tin oxide. In such a circuit member connection structure, it is possible to further reduce the resistance value between the opposed circuit electrodes while maintaining the insulation between the circuit electrodes neighboring on the same circuit member.

Also, in the circuit member connection structure of the present invention, preferably, at least one of the first and the second circuit substrates is a substrate made of a material comprising at least one resin selected from the group consisting of polyethylene terephthalate, polyethersulfone, epoxy resins, acrylic resins, polyimide resins, and glass. When the above circuit connecting material of the present invention is cured to form the circuit connecting portion, it can exhibit higher adhesive strength between the substrates composed of these specific materials.

Further, in the above circuit member connection structure, preferably, a layer comprising at least one resin selected from the group consisting of silicone resins, acrylic resins, and polyimide resins is formed between at least one of the first and the second circuit members and the above-described circuit connecting portion. Thus, the adhesive strength between the circuit member and the circuit connecting portion is further improved, compared with those in which the above layer is not formed.

The present invention provides a method for manufacturing a circuit member connection structure, comprising the steps of arranging a first circuit member having a first circuit electrode formed on a major surface of a first circuit substrate and a second circuit member having a second circuit electrode formed on a major surface of a second circuit substrate so that the first circuit electrode and the second circuit electrode are located opposed to each other, heating and pressurizing a laminate formed by interposing the above-described circuit connecting material between the first circuit member and the second circuit member in a direction of its lamination, and connecting the first circuit member and the second circuit member so that the first and the second circuit electrodes are electrically connected.

This manufacturing method uses the circuit connecting material of the present invention that exhibits sufficiently good adhesive strength, without depending on the materials of the circuit members, and has sufficiently excellent transferability, with the change in transferability over time suppressed. Therefore, it is possible to manufacture a circuit member connection structure in which the resistance value between the opposed circuit electrodes is sufficiently reduced while the insulation between neighboring circuit electrodes is maintained.

### Effect of the Invention

According to the present invention, it is possible to provide a circuit connecting material that exhibits sufficiently good adhesive strength, without depending on the materials of the circuit members, and has sufficiently excellent transferability, with the change in transferability over time suppressed, a circuit member connection structure using the same, and a method for manufacturing a circuit member connection structure.

### Brief Description of the Drawings

Figure 1 is a schematic cross-sectional view showing one embodiment of a circuit member connection structure according to the present invention; and
Figure 2 is a process diagram showing one embodiment of a method for manufacturing a circuit member connection structure according to the present invention by a schematic cross-sectional view.

### Description of Symbols

1: circuit member circuit connection structure, 5: adhesive component, 7: conductive particle, 10: circuit connecting portion, 11: insulating layer, 20: first circuit member, 21: first circuit substrate, 21a: major surface of first circuit substrate, 22: first circuit electrode, 30: second circuit member, 31: second circuit substrate, 31a: major surface of second circuit substrate, 32: second circuit electrode, 40: film-like circuit connecting material.

### Best Mode for Carrying Out the Invention

Preferred embodiments of the present invention will be described below in detail, with reference to the drawings as required. In the drawings, like numerals refer to like elements, and redundant description is omitted. Also, positional relationship, such as top and bottom, and left and light, is based on the positional relationship shown in the drawing, unless otherwise specified. Further, the dimensional ratio in the drawings is not limited to the ratio shown. Also, "(meth)acrylic acid" in this specification means "acrylic acid" and "methacrylic acid" corresponding to the acrylic acid, and "(meth)acrylate" means "acrylate" and "methacrylate" corresponding to the acrylate.

### (Circuit connecting Material)

The circuit connecting material of the present invention is a circuit connecting material for electrically connecting a first circuit member having a first circuit electrode formed on a major surface of a first circuit substrate, and a second circuit member having a second circuit electrode formed on a major surface of a second circuit substrate, with the first and the second circuit electrodes opposed to each other, comprising an adhesive component containing a fluorine-containing organic compound, wherein the adhesive component contains 0.10% or less by mass of a silicon-containing compound, in terms of silicon atoms, based on the total amount of the adhesive component.

The adhesive component contains at least a fluorine-containing organic compound. The fluorine-containing organic compound used in the present invention should be a compound having fluorine in the molecule and may be a publicly known one. The fluorine-containing organic compounds specifically include, for example, radically polymerizable fluorine-containing organic compounds, fluorine-containing polyvinyl butyral resins, fluorine-containing polyvinyl formal resins, fluorine-containing polyimide resins, fluorine-containing polyamide resins, fluorine-containing polyamideimide resins, fluorine-containing polyester resins, fluorine-containing phenolic resins, fluorine-containing epoxy resins, fluorine-containing phenoxy resins, fluorine-containing polyurethane resins, fluorine-containing polyester urethane resins, fluorine-containing polyarylate resins, fluorine-containing styrene resins, fluorine-containing silicone resins, fluorine-containing acrylic rubbers, fluorine-containing nitrile rubbers, fluorine-containing NBRs, and fluorine-containing SBSs. These are used alone, or two types or more of these are mixed and used. When the circuit connecting material contains these fluorine-containing organic compounds as the adhesive component, the circuit connecting material exhibits sufficiently good adhesive strength, without depending on the materials of the circuit members, and has sufficiently excellent transferability, with the change in transferability over time suppressed. Among these, radically polymerizable fluorine-containing organic compounds, fluorine-containing polyimide resins, or fluorine-containing epoxy resins are particularly preferred. Also, the fluorine-containing organic compounds may be those in which the above-described fluorine-containing resins are modified with radically polymerizable functional groups. Thus, the heat resistance of the cured product of the circuit connecting material is further improved.

The radically polymerizable fluorine-containing organic compounds according to the present invention are those having radically polymerizable functional groups, and for example, fluorine-containing (meth)acrylic acid compounds, fluorine-containing maleimide compounds, or fluorine-containing styrene derivatives are preferably used. These radically polymerizable fluorine-containing organic compounds may be either of polymerizable monomers and polymerizable oligomers, and it is also possible to use a polymerizable monomer and a polymerizable oligomer in combination. Polymerizable oligomers generally have high viscosity, so that when a polymerizable oligomer is used, a polymerizable monomer, such as polymerizable polyfunctional (meth)acrylate having low viscosity, is preferably used in combination to adjust the viscosity.

The radically polymerizable fluorine-containing organic compounds can also be used in combination with radically polymerizable compounds containing no fluorine.

The fluorine-containing (meth)acrylic acid compounds are those in which fluorine atoms are introduced into (meth)acrylic acid compounds. The (meth)acrylic acid compounds include, for example, photopolymerizable oligomers such as epoxy (meth)acrylate oligomers, urethane (meth)acrylate oligomers, polyether (meth)acrylate oligomers and polyester (meth)acrylate oligomers, polyfunctional (meth)acrylate compounds such as trimethylolpropane tri(meth)acrylate, polyethylene glycol di(meth)acrylate, polyalkylene glycol di(meth)acrylate, dicyclopentenyl (meth)acrylate, dicyclopentenyloxyethyl (meth)acrylate, neopentylglycol di(meth)acrylate, dipentaerythritol hexa(meth)acrylate, isocyanuric acid-modified bifunctional (meth)acrylate, isocyanuric acid-modified trifunctional (meth)acrylate, 2,2'-di(meth)acryloyloxydiethyl phosphate and 2-(meth)acryloyloxyethyl acid phosphate, pentaerythritol (meth)acrylate, 2-cyanoethyl (meth)acrylate, cyclohexyl (meth)acrylate, 2-(2-ethoxyethoxy)ethyl (meth)acrylate, 2-ethoxyethyl (meth)acrylate, 2-ethylhexyl (meth)acrylate, n-hexyl (meth)acrylate, 2-hydroxyethyl (meth)acrylate, hydroxypropyl (meth)acrylate, isobornyl (meth)acrylate, isodecyl (meth)acrylate, isooctyl (meth)acrylate, n-lauryl (meth)acrylate, 2-methoxyethyl (meth)acrylate, 2-phenoxyethyl (meth)acrylate, tetrahydrofurfuryl (meth)acrylate, neopentylglycol di(meth)acrylate, t-butylaminoethyl (meth)acrylate, cyclohexyl (meth)acrylate, dicyclopentenyloxyethyl (meth)acrylate, 2-hydroxyethyl (meth)acrylate, isobornyl (meth)acrylate, isodecyl (meth)acrylate, n-lauryl (meth)acrylate, stearyl (meth)acrylate, tridecyl (meth)acrylate and glycidyl (meth)acrylate.

One fluorine-containing (meth)acrylic acid compound is used alone, or two or more fluorine-containing (meth)acrylic acid compounds are used in combination. A urethane (meth)acrylate oligomer is preferably compounded to suppress the curing shrinkage of the circuit connecting material and provide flexibility.

The fluorine-containing maleimide compounds are those in which fluorine atoms are introduced into maleimide compounds. As the maleimide compounds, those containing two or more maleimide groups in the molecule are preferred. Specific examples of the maleimide compounds include 1-methyl-2,4-bismaleimidebenzene, N,N'-m-phenylenebismaleimide, N,N'-p-phenylenebismaleimide, N,N'-m-toluylenebismaleimide, N,N-'4,4-biphenylenebismaleimide, N,N-'4,4-(3,3'-dimethyl-biphenylene)bismaleimide, N,N-'4,4-(3,3'-dimethyldiphenylmethane)bismaleimide, N,N-'4,4-(3,3'-diethyldiphenylmethane)bismaleimide, N,N-'4,4-diphenylmethanebismaleimide, N,N-'4,4-diphenylpropanebismaleimide, N,N-'4,4-diphenyletherbismaleimide, N,N'-3,3'-diphenylsulfonebismaleimide, 2,2-bis [4-(4-maleimidephenoxy)phenyl]propane, 2,2-bis[3-s-butyl-4-(4-maleimidephenoxy)phenyl]propane, 1,1-bis[4-(4-maleimidephenoxy)phenyl]decane, 4,4'-cyclohexylidene-bis[1-(4-maleimidephenoxy)-2-cyclohexylbenzene] and 2,2-bis[4-(4-maleimidephenoxy)phenyl]hexafluoropropane.

One fluorine-containing maleimide compound is used alone, or two or more fluorine-containing maleimide compounds are used in combination.

When the circuit connecting material of the present invention contains a radically polymerizable fluorine-containing organic compound as the fluorine-containing organic compound, the circuit connecting material preferably further contains a radical polymerization initiator. Once a radically polymerizable compound initiates radical polymerization reaction, chain reaction proceeds, and firm curing is possible, but it is relatively difficult to first generate a radical. Therefore, in the present invention, the circuit connecting material preferably contains a radical polymerization initiator that can relatively easily produce a radical.

As the radical polymerization initiator according to the present invention, compounds that are decomposed by at least either one treatment of heating and light irradiation to generate a free radical, such as conventionally known peroxide compounds (organic peroxides), azo compounds, or photoinitiators, are used.

The organic peroxides and the azo compounds generate a free radical mainly by heating. When these compounds are used as the radical polymerization initiator, one or two or more are appropriately selected from organic peroxides and/or azo compounds according to the intended connection temperature, connection time and pot life, and the like.

As the organic peroxides, organic peroxides having a 10-hour half-life temperature of 40°C or more, and a 1-minute half-life temperature of 180°C or less are preferred, and organic peroxides having a 10-hour half-life temperature of 60°C or more, and a 1-minute half-life temperature of 170°C or less are more preferred, from the viewpoint of providing both high reactivity and long pot life. Also, in the organic peroxides, the content of chlorine ions and organic acid is preferably 5000 ppm or less by mass to prevent the corrosion of the circuit electrodes (connection terminals) of the circuit members. Further, organic peroxides generating a small amount of organic acid after decomposition by heating are more preferred.

As the organic peroxides, specifically, one or more organic peroxides selected from the group consisting of diacyl peroxide, peroxydicarbonate, peroxyester, peroxyketal, dialkyl peroxide, hydroperoxide and silyl peroxide are preferred. Among these, one or more organic peroxides selected from the group consisting of peroxyester, peroxyketal, dialkyl peroxide, hydroperoxide and silyl peroxide are more preferred from the viewpoint of providing both high storage stability during storage and high reactivity during use. Further, the organic peroxide is further preferably peroxyester and/or peroxyketal in that higher reactivity is obtained.

Diacyl peroxide includes, for example, isobutyl peroxide, 2,4-dichlorobenzoyl peroxide, 3,5,5-trimethylhexanoyl peroxide, octanoyl peroxide, lauroyl peroxide, stearoyl peroxide, succinic peroxide, benzoylperoxytoluene and benzoyl peroxide. One of these is used alone, or two or more of these are used in combination.

Dialkyl peroxide includes, for example, α,α'-bis(t-butylperoxy)diisopropylbenzene, dicumyl peroxide, 2,5-dimethyl-2,5-di(t-butylperoxy)hexane and t-butylcumyl peroxide. One of these is used alone, or two or more of these are used in combination.

Peroxydicarbonate includes, for example, di-n-propyl peroxydicarbonate, diisopropyl peroxydicarbonate, bis(4-t-butylcyclohexyl) peroxydicarbonate, di-2-ethoxymethoxy peroxydicarbonate, bis(2-ethylhexylperoxy) dicarbonate, dimethoxybutyl peroxydicarbonate and bis(3-methyl-3-methoxybutylperoxy) dicarbonate. One of these is used alone, or two or more of these are used in combination.

Peroxyester includes, for example, cumyl peroxyneodecanoate, 1,1,3,3-tetramethylbutyl peroxyneodecanoate, 1-cyclohexyl-1-methylethyl peroxyneodecanoate, t-hexyl peroxyneodecanoate, t-butyl peroxypivalate, 1,1,3,3-tetramethylbutyl peroxy-2-ethylhexanoate, 2,5-dimethyl-2,5-bis(2-ethylhexanoylperoxy)hexane, 1-cyclohexyl-1-methylethyl peroxy-2-ethylhexanoate, t-hexyl peroxy-2-ethylhexanoate, t-butyl peroxy-2-ethylhexanoate, t-butyl peroxyisobutyrate, 1,1-bis(t-butylperoxy)cyclohexane, t-hexyl peroxyisopropylmonocarbonate, t-butyl peroxy-3,5,5-trimethylhexanoate, t-butyl peroxylaurate, 2,5-dimethyl-2,5-bis(m-toluoylperoxy)hexane, t-butyl peroxy isopropyl monocarbonate, t-butyl peroxy-2-ethylhexyl monocarbonate, t-hexyl peroxybenzoate, t-butyl peroxyacetate and bis(t-butylperoxy) hexahydroterephthalate. One of these is used alone, or two or more of these are used in combination.

Peroxyketal includes, for example, 1,1-bis(t-hexylperoxy)-3,3,5-trimethylcyclohexane, 1,1-bis(t-hexylperoxy)cyclohexane, 1,1-bis(t-butylperoxy)-3,3,5-trimethylcyclohexane, 1,1-(t-butylperoxy)cyclododecane and 2,2-bis(t-butylperoxy)decane. One of these is used alone, or two or more of these are used in combination.

Hydroperoxide includes, for example, diisopropylbenzene hydroperoxide and cumene hydroperoxide. One of these is used alone, or two or more of these are used in combination.

Silyl peroxide includes, for example, t-butyltrimethylsilyl peroxide, bis(t-butyl)dimethylsilyl peroxide, t-butyltrivinylsilyl peroxide, bis(t-butyl)divinylsilyl peroxide, tris(t-butyl)vinylsilyl peroxide, t-butyltriallylsilyl peroxide, bis(t-butyl)diallylsilyl peroxide and tris(t-butyl)allylsilyl peroxide. One of these is used alone, or two or more of these are used in combination.

When these organic peroxides are used, a decomposition accelerator, an inhibitor, and the like may be further used in combination. Also, these organic peroxides are preferably those covered with polyurethane-based or polyester-based polymer substances or the like for microencapsulation because the usable life is extended.

Also, the azo compounds include, for example, 2,2'-azobis-2,4-dimethylvaleronitrile, 1,1'-azobis(1-acetoxy-1-phenylethane), 2,2'-azobisisobutyronitrile, 2,2'-azobis(2-methylbutyronitrile), dimethyl-2,2'-azobisisobutyronitrile, 4,4'-azobis(4-cyanovaleric acid) and 1,1'-azobis(1-cyclohexanecarbonitrile). One of these is used alone, or two or more of these are used in combination.

On the other hand, the photoinitiators are not particularly limited, as long as the above-described organic peroxides and azo compounds are excluded. Specific examples of the photoinitiators include benzoin ether such as benzoin ethyl ether and isopropyl benzoin ether, benzyl ketal such as benzyl and hydroxycyclohexyl phenyl ketone, ketones such as benzophenone and acetophenone, and their derivatives, thioxanthones and bisimidazoles. One of these is used alone, or two or more of these are used in combination.

A sensitizer, such as an amine compound, a sulfur compound and a phosphorus compound, may be added as required, in any proportion, to the above photoinitiator. When the photoinitiator is used as the radical polymerization initiator, a preferred photoinitiator is selected according to the wavelength of a light source used for light irradiation, and the intended curing properties of the circuit connecting material.

The sensitizers include, for example, aliphatic amine, aromatic amine, alicyclic amine such as piperidine, o-tolylthiourea, sodium diethyl dithiophosphate, soluble salts of aromatic sulfinic acid, N,N'-dimethyl-p-aminobenzonitrile, N,N'-diethyl-p-aminobenzonitrile, N,N'-di(β-cyanoethyl)-p-aminobenzonitrile, N,N'-di(β-chloroethyl)-p-aminobenzonitrile and tri-n-butylphosphine.

Further, as the sensitizer, non-dye-based sensitizers, such as propiophenone, acetophenone, xanthone, 4-methylacetophenone, benzophenone, fluorene, triphenylene, biphenyl, thioxanthone, anthraquinone, 4,4'-bis(dimethylamino)benzophenone, 4,4'-bis(diethylamino)benzophenone, phenanthrene, naphthalene, 4-phenylacetophenone, 4-phenylbenzophenone, 1-iodonaphthalene, 2-iodonaphthalene, acenaphthene, 2-naphthonitrile, 1-naphthonitrile, chrysene, benzyl, fluoranthene, pyrene, 1,2-benzanthracene, acridine, anthracene, perylene, tetracene, and 2-methoxynaphthalene, and dye-based sensitizers, such as thionine, methylene blue, lumiflavin, riboflavin, lumichrome, coumarin, psoralen, 8-methoxypsoralen, 6-methylcoumarin, 5-methoxypsoralen, 5-hydroxypsoralen, coumarylpyrone, acridine orange, acriflavine, proflavin, fluorescein, eosine Y, eosine B, erythrosine and rose bengal, can be used.

One of the above-described sensitizers is used alone, or two or more of the above-described sensitizers are used in combination.

The compounding proportion of the radical polymerization initiator can be appropriately set according to the intended connection temperature, connection time, and pot life, and the like. For example, when the connection time is 10 seconds or less, the compounding proportion of the radical polymerization initiator is preferably 0.1 to 30 parts by mass, and more preferably 1 to 20 parts by mass, based on 100 parts by mass of the total of the adhesive component, to obtain a sufficient reaction rate. If the compounding proportion of the radical polymerization initiator is less than 0.1 part by mass, the reaction rate decreases, so that there is a tendency that the circuit connecting material is not easily cured. If the compounding proportion of the radical polymerization initiator is more than 30 parts by mass, there are tendencies that the flowability of the circuit connecting material decreases, that the connection resistance increases, and that the pot life of the circuit connecting material is shortened. However, from the viewpoint of achieving the object of the present invention, when the adhesive component comprises silyl peroxide, the content proportion of silyl peroxide is 0.10% or less by mass, in terms of silicon atoms, based on the total amount of the adhesive component.

The fluorine-containing polyimide resin according to the present invention can be obtained by subjecting, for example, fluorine-containing tetracarboxylic dianhydride and a diamine compound, tetracarboxylic dianhydride and a fluorine-containing diamine compound, or fluorine-containing tetracarboxylic dianhydride and a fluorine-containing diamine compound to condensation reaction by a publicly known method.

For example, using the same moles or substantially the same moles of tetracarboxylic dianhydride, which may have a fluorine atom, and a diamine compound, which may have a fluorine atom, in an organic solvent, these substances are subjected to addition reaction (the order of adding the substances is optional) at a reaction temperature of 80°C or less, preferably 0 to 60°C. The above organic solvent includes dimethylacetamide, dimethylformamide, N-methyl-2-pyrrolidone, dimethylsulfoxide, hexamethylphosphorylamide, m-cresol, o-chlorphenol and the like. As the reaction proceeds, the viscosity of the reaction solution increases gradually, producing polyamide acid that is a precursor of polyimide. The molecular weight of this polyamide acid can be adjusted by heating at a temperature of 50 to 80°C for depolymerization.

The above polyimide resin can be obtained by subjecting the above-described reaction product (polyamide acid) to dehydration and ring closure. The dehydration and ring closure method includes a thermal ring closure method in which heating treatment is performed at 120 to 250°C, and a chemical ring closure method using a dehydrator. In the case of the thermal ring closure method, preferably, dehydration and ring closure are performed while water produced in the dehydration reaction is removed out of the system. At this time, water may be removed by azeotropy, using benzene, toluene, xylene, or the like. In the case of the chemical ring closure method, acid anhydride, that is, acetic anhydride, propionic anhydride or benzoic anhydride, a carbodiimide compound, such as dicyclohexylcarbodiimide or the like is preferably used as the dehydrator. At this time, a ring closure catalyst, such as pyridine, isoquinoline, trimethylamine, aminopyridine and imidazole, may be used as required. The dehydrator or the ring closure catalyst is preferably used in the range of 1 to 8 moles with respect to 1 mole of tetracarboxylic dianhydride.

The tetracarboxylic dianhydride includes, for example, 1,2-(ethylene)bis(trimellitate anhydride), 1,3-(trimethylene)bis(trimellitate anhydride), 1,4-(tetramethylene)bis(trimellitate anhydride), 1,5-(pentamethylene)bis(trimellitate anhydride), 1,6-(hexamethylene)bis(trimellitate anhydride), 1,7-(heptamethylene)bis(trimellitate anhydride), 1,8-(octamethylene)bis(trimellitate anhydride), 1,9-(nonamethylene)bis(trimellitate anhydride), 1,10-(decamethylene)bis(trimellitate anhydride), 1,12-(dodecamethylene)bis(trimellitate anhydride), 1,16-(hexadecamethylene)bis(trimellitate anhydride), 1,18-(octadecamethylene)bis(trimellitate anhydride), pyromellitic dianhydride, 3,3',4,4'-biphenyltetracarboxylic dianhydride, 2,2',3,3'-biphenyltetracarboxylic dianhydride, 2,2-bis(3,4-dicarboxyphenyl)propane dianhydride, 2,2-bis(2,3-dicarboxyphenyl)propane dianhydride, 1,1-bis(2,3-dicarboxyphenyl)ethane dianhydride, 1,1-bis(3,4-dicarboxyphenyl)ethane dianhydride, bis(2,3-dicarboxyphenyl)methane dianhydride, bis(3,4-dicarboxyphenyl)methane dianhydride, bis(3,4-dicarboxyphenyl)sulfone dianhydride, 3,4,9,10-perylenetetracarboxylic dianhydride, bis(3,4-dicarboxyphenyl)ether dianhydride, benzene-1,2,3,4-tetracarboxylic dianhydride, 3,4,3',4'-benzophenonetetracarboxylic dianhydride, 2,3,2',3'-benzophenonetetracarboxylic dianhydride, 3,3,3',4'-benzophenonetetracarboxylic dianhydride, 1,2,5,6-naphthalenetetracarboxylic dianhydride, 1,4,5,8-naphthalenetetracarboxylic dianhydride, 2,3,6,7-naphthalenetetracarboxylic dianhydride, 1,2,4,5-naphthalenetetracarboxylic dianhydride, 2,6-dichloronaphthalene-1,4,5,8-tetracarboxylic dianhydride, 2,7-dichloronaphthalene-1,4,5,8-tetracarboxylic dianhydride, 2,3,6,7-tetrachloronaphthalene-1,4,5,8-tetracarboxylic dianhydride, phenanthrene-1,8,9,10-tetracarboxylic dianhydride, pyrazine-2,3,5,6-tetracarboxylic dianhydride, thiophene-2,3,5,6-tetracarboxylic dianhydride, 2,3,3',4-biphenyltetracarboxylic dianhydride, 3,4,3',4-biphenyltetracarboxylic dianhydride, 2,3,2',3'-biphenyltetracarboxylic dianhydride, bis(3,4-dicarboxyphenyl)dimethylsilane dianhydride, bis(3,4-dicarboxyphenyl)methylphenylsilane dianhydride, bis(3,4-dicarboxyphenyl)diphenylsilane dianhydride, 1,4-bis(3,4-dicarboxyphenyldimethylsilyl)benzene dianhydride, 1,3-bis(3,4-dicarboxyphenyl)-1,1,3,3-tetramethyldicyclohexane dianhydride, p-phenylenebis(trimellitate anhydride), ethylenetetracarboxylic dianhydride, 1,2,3,4-butanetetracarboxylic dianhydride, decahydronaphthalene-1,4,5,8-tetracarboxylic dianhydride, 4,8-dimethyl-1,2,3,5,6,7-hexahydronaphthalene-1,2,5,6-tetracarboxylic dianhydride, cyclopentane-1,2,3,4-tetracarboxylic dianhydride, pyrrolidine-2,3,4,5-tetracarboxylic dianhydride, 1,2,3,4-cyclobutanetetracarboxylic dianhydride, bis(exo-bicyclo[2,2,1]heptane-2,3-dicarboxylic dianhydrid), bicyclo-[2,2,2]-octo-7-ene-2,3,5,6-tetracarboxylic dianhydride, 4,4'-bis(3,4-dicarboxyphenoxy)diphenyl sulfide dianhydride, 5-(2,5-dioxotetrahydrofuryl)-3-methyl-3-cyclohexene-1,2-dicarboxylic dianhydride, tetrahydrofuran-2,3,4,5-tetracarboxylic dianhydride and 4,4'-(4,4'-isopropylidenediphenoxy)bis(phthalic dianhydrid). These are used alone, or two or more of these are used in combination.

The fluorine-containing tetracarboxylic dianhydride includes those in which the hydrogen atom of the above-described tetracarboxylic dianhydride is substituted with a fluorine atom. More specifically, the fluorine-containing tetracarboxylic dianhydride includes 2,2-bis(3,4-dicarboxyphenyl)hexafluoropropane dianhydride (also known as "4,4'-hexafluoropropylidenic dianhydride) and 2,2,-bis[4-(3,4-dicarboxyphenyl)phenyl]hexafluoropropane dianhydride.

The diamine compounds include, for example, aromatic diamines such as o-phenylenediamine, m-phenylenediamine, p-phenylenediamine, 3,3'-diaminodiphenylether, 3,4'-diaminodiphenylether, 4,4'-diaminodiphenylether, 3,3'-diaminodiphenylmethane, 3,4'-diaminodiphenylmethane, 4,4'-diaminodiphenylmethane, bis(4-amino-3,5-dimethylphenyl)methane, bis(4-amino-3,5-diisopropylphenyl)methane, 3,3'-diaminodiphenyl sulfone, 3,4'-diaminodiphenyl sulfone, 4,4'-diaminodiphenyl sulfone, 3,3'-diaminodiphenyl sulfide, 3,4'-diaminodiphenyl sulfide, 4,4'-diaminodiphenyl sulfide, 3,3'-diaminodiphenyl ketone, 3,4'-diaminodiphenyl ketone, 4,4'-diaminodiphenyl ketone, 2,2-bis(3-aminophenyl)propane, 2,2'-(3,4'-diaminodiphenyl)propane, 2,2-bis(4-aminophenyl)propane, 1,3-bis(3-aminophenoxy)benzene, 1,4-bis(3-aminophenoxy)benzene, 1,4-bis(4-aminophenoxy)benzene, 3,3'-(1,4-phenylenebis(1-methylethylidene))bisaniline, 3,4'-(1,4-phenylenebis(1-methylethylidene))bisaniline, 4,4'-(1,4-phenylenebis(1-methylethylidene))bisaniline, 2,2-bis(4-(3-aminophenoxy)phenyl)propane, 2,2-bis(4-(4-aminophenoxy)phenyl)propane, bis(4-(3-aminophenoxy)phenyl)sulfide, bis(4-(4-aminophenoxy)phenyl)sulfide, bis(4-(3-aminophenoxy)phenyl)sulfone, bis(4-(4-aminophenoxy)phenyl)sulfone and 3,5-diaminobenzoic acid, and aliphatic diamines such as 1,2-diaminoethane, 1,3-diaminopropane, 1,4-diaminobutane, 1,5-diaminopentane, 1,6-diaminohexane, 1,7-diaminoheptane, 1,8-diaminooctane, 1,9-diaminononane, 1,10-diaminodecane, 1,11-diaminoundecane, 1,12-diaminododecane, 1,2-diaminocyclohexane, diaminopolysiloxane represented by the following general formula (1), 1,3-bis(aminomethyl)cyclohexane and polyoxyalkylenediamines such as the trade name JEFFAMINE D-230, D-400, D-2000, D-4000, ED-600, ED-900, ED-2001 and EDR-148, manufactured by Sun Technochemical.

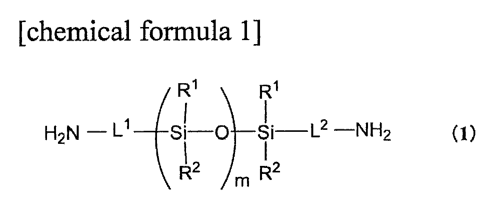

In formula (1), L¹ and L² each independently represent a divalent hydrocarbon group having 1 to 30 carbon atoms and may be the same or different from each other. R¹ and R² each independently represent a monovalent hydrocarbon group having preferably 1 to 30, more preferably 1 to 20, and particularly preferably 1 to 10 carbon atoms, and may be the same or different from each other. m represents an integer of 1 or more.

The fluorine-containing diamine compounds include those in which the hydrogen atoms of the above-described diamine compounds are substituted with fluorine atoms. More specifically, the fluorine-containing diamine compounds include 3,3'-diaminodiphenyldifluoromethane, 3,4'-diaminodiphenyldifluoromethane, 4,4'-diaminodiphenyldifluoromethane, 2,2-bis(3-aminophenyl)hexafluoropropane, 2,2-(3,4'-diaminodiphenyl)hexafluoropropane, 2,2-bis(4-aminophenyl)hexafluoropropane, 2,2-bis(4-(3-aminophenoxy)phenyl)hexafluoropropane and 2,2-bis(4-(4-aminophenoxy)phenyl)hexafluoropropane.

The above-described fluorine-containing tetracarboxylic dianhydride and fluorine-containing diamine compounds may be used in combination with the above-described tetracarboxylic dianhydride and diamine compounds having no fluorine.

The fluorine-containing polyimide resins have excellent solubility and compatibility due to having fluorine, have high adhesiveness to inorganic substances, such as glass and metal, and also have excellent heat resistance due to having an imide structure. Also, fluorine-containing polyimide resins modified with chlorine, hydroxyl groups or carboxyl groups are more preferred from the viewpoint of compatibility and adhesiveness.

The fluorine-containing epoxy resins according to the present invention are preferably those having two or more glycidyl groups in one molecule. The fluorine-containing epoxy resins are, for example, those in which hydrogen atoms in epoxy resins are substituted with fluorine atoms. The epoxy resins include, for example, bisphenol type epoxy resins derived from epichlorohydrin and bisphenol A, F, or AD, epoxy novolak resins derived from epichlorohydrin and phenol novolak or cresol novolak, naphthalene type epoxy resins having a skeleton comprising a naphthalene ring, glycidyl amine type epoxy resins, glycidyl ether type epoxy resins, biphenyl type epoxy resins and alicyclic type epoxy resins.

One fluorine-containing epoxy resin is used alone, or two or more fluorine-containing epoxy resins are used in combination. Also, the fluorine-containing epoxy resins can be used in combination with the above epoxy resins containing no fluorine.

These epoxy resins are preferably high-purity products, in which impurity ions (N⁺, Cr⁻, and the like), hydrolyzable chlorine and the like are reduced to 300 ppm or less by mass, to prevent electron migration.

Also, when the circuit connecting material of the present invention contains the fluorine-containing epoxy resin, the circuit connecting material preferably further contains an epoxy resin curing agent. The epoxy resin curing agent according to the present invention is preferably a latent curing agent from the viewpoint of obtaining longer pot life. The latent curing agent includes, for example, an imidazole type, a hydrazide type, boron trifluoride-amine complexes, sulfonium salts, amine imide, polyamine salts and dicyandiamide. Also, from the viewpoint of extending the usable life, these curing agents are preferably those covered with polyurethane-based or polyester-based polymer substances or the like for microencapsulation. One of these epoxy resin curing agents is used alone, or two or more of these epoxy resin curing agents are mixed and used. When the epoxy resin curing agent is used, a decomposition accelerator, an inhibitor, and the like may be used in combination.

The compounding proportion of the epoxy resin curing agent is preferably 0.1 to 60 parts by mass, and more preferably 1 to 20 parts by mass, based on 100 parts by mass of the adhesive component, to obtain a sufficient reaction rate. If the compounding proportion of the epoxy resin curing agent is less than 0.1 part by mass, the reaction rate decreases, so that there are tendencies that the adhesive strength decreases, and that the connection resistance increases. If the compounding proportion of the epoxy resin curing agent is more than 60 parts by mass, there are tendencies that the flowability of the circuit connecting material decreases, that the connection resistance increases, and that the pot life of the circuit connecting material is shortened.

Also, the weight average molecular weight of the fluorine-containing organic compound is preferably 5000 to 1000000 and more preferably 20000 to 200000 from the viewpoint of excellent stress relaxation properties during curing, and a further improvement in adhesiveness. If the weight average molecular weight of the fluorine-containing organic compound is less than 5000, there is a tendency that the film formability is insufficient when the circuit connecting material is used as a film described below. If the weight average molecular weight is more than 1000000, there is a tendency that the compatibility with other components is poor.

The weight average molecular weight in this specification is obtained by measurement by gel permeation chromatography (GPC) analysis according to conditions shown in Table 1, and conversion using the calibration curve of standard polystyrene. Here, GPC conditions 1 are conditions when the weight average molecular weight of the fluorine-containing polyimide resins is measured, and GPC conditions 2 are conditions when the weight average molecular weight of fluorine-containing organic compounds other than the fluorine-containing polyimide resins is measured.

**[Table 1]**

| | GPC conditions 1 | GPC conditions 2 |
|---|---|---|
| Equipment used | High-speed liquid chromatography C-R4A | Hitachi L-6000 type |
| | (trade name, manufactured by SHIMADZU CORPORATION) | (trade name, manufactured by Hitachi, Ltd.) |
| Detector | L-4200 | L-3300RI |
| | (manufactured by Hitachi, Ltd.) | (trade name, manufactured by Hitachi, Ltd.) |
| Column | G6000HXL | Gelpack GL-R420 |
| | G4000HXL | Gelpack GL-R430 |
| | G2000HXL | Gelpack GL-R440 |
| | (trade name, manufactured by TOSOH CORPORATION) | (trade name, manufactured by Hitachi Chemical Company, Ltd.) |
| Eluent | lithium bromide (LiBr)/ N,N-dimethylformamide (DMF) (0.03mol/L) phosphoric acid (0.06mol/L) | tetrahydrofuran |
| Measurement Temperature | 30°C | 40°C |
| Flow Rate | 1.0ml/min | 1.75ml/min |

Also, from the viewpoint of improving the ease of handling, and the heat resistance of the circuit connecting material, the glass transition temperature of the fluorine-containing organic compound is preferably 50°C or more. The upper limit value of the glass transition temperature of the fluorine-containing organic compound is not particularly limited.

Further, from the viewpoint of improving the heat resistance of the circuit connecting material, the fluorine-containing organic compound preferably has an aromatic group and/or an alicyclic group. The aromatic group includes, for example, a phenyl group and a phenylene group. The alicyclic group includes, for example, a cyclohexyl group and a cyclohexylene group.

Also, the fluorine-containing organic compound is preferably soluble in an organic solvent. In a circuit connecting material in which the fluorine-containing organic compound is only dispersed in an organic solvent, layer separation may occur during storage. In this case, imbalance in the composition of the adhesive component included in the circuit connecting material occurs, easily causing decreases in the adhesiveness and transferability of the obtained circuit connecting material to the circuit members. On the other hand, when the fluorine-containing organic compound is soluble in an organic solvent, layer separation does not occur easily even if they are left in a solution state, so that imbalance in the composition of the adhesive component included in the circuit connecting material does not occur easily. Therefore, the obtained circuit connecting material has excellent adhesiveness and transferability to the circuit members. Here, being soluble in an organic solvent means that 1% or more by mass of the fluorine-containing organic compound is dissolved in the organic solvent at 25°C. Preferably, 10% or more by mass of the fluorine-containing organic compound is dissolved in the organic solvent.

The organic solvent is not particularly limited as long as it is one generally used in the circuit connecting material. The organic solvent includes, for example, methyl ethyl ketone, tetrahydrofuran, toluene, and ethyl acetate. One of these organic solvents can be used alone, or two or more of these organic solvents can be mixed and used.

Thus, the fluorine-containing organic compound is also soluble in an organic solvent having a relatively low boiling point, such as methyl ethyl ketone, so that the solvent selection range when the circuit connecting material contains an organic solvent is widened, and a circuit connecting material in which the adhesive component is not easily localized can be fabricated. Therefore, the obtained circuit connecting material has further excellent adhesiveness and transferability to the circuit members.

In the circuit connecting material of the present invention, the adhesive component contains 0.10% or less by mass of a silicon-containing compound, in terms of silicon atoms, based on the total amount of the adhesive component. The silicon-containing compound may be one included in the adhesive component apart from the above-described fluorine-containing organic compound, or may be one having a silicon atom in the molecule of the above-described fluorine-containing organic compound. In other words, the adhesive component according to the present invention may contain a fluorine-containing organic compound and a silicon-containing compound different from the fluorine-containing organic compound, or may contain only a fluorine-containing organic compound having a silicon atom in the molecule, as a silicon-containing compound.

When the silicon-containing compound is one having a silicon atom in the molecule of the above fluorine-containing organic compound, the silicon-containing compound is preferably one in which a silicone structure is introduced into the above-described fluorine-containing organic compound, that is, a fluorine-containing organic compound having a silicone structure, from the viewpoint of further improving the adhesiveness to glass, which is a circuit substrate, and the surface of the circuit member coated with a silicone resin. Such silicon-containing compounds include, for example, compounds in which radically polymerizable fluorine-containing organic compounds, fluorine-containing polyimide resins, and fluorine-containing epoxy resins are respectively modified with silicone. More specifically, the silicon-containing compounds include fluorine-containing polyimide resins obtained by subjecting fluorine-containing tetracarboxylic dianhydride, and diaminopolysiloxane represented by the above general formula (1) to condensation reaction by a publicly known method.

If the content of the silicon-containing compound is more than 0.10% by mass, in terms of silicon atoms, based on the total amount of the adhesive component, the adhesiveness to the circuit members is improved, but the tackiness to the supporting substrate increases over time. As a result, there is a tendency to cause a decrease in transferability. Therefore, the adhesive component more preferably contains no silicon-containing compound.

From a similar viewpoint, when the adhesive component contains the fluorine-containing polyimide resin, the content of the silicon-containing compound in the fluorine-containing polyimide resin is preferably 1% or less by mass, in terms of silicon atoms.

In the circuit connecting material of the present invention, the adhesive component preferably further contains phosphate type (meth)acrylate for the purpose of improving the adhesiveness. The adhesive component containing phosphate type (meth)acrylate improves the adhesive strength of the circuit connecting material to particularly inorganic materials, such as metal. As phosphate type (meth)acrylate, publicly known ones can be used without particular limitation. Specific examples of phosphate type (meth)acrylate include compounds represented by the following general formula (2): 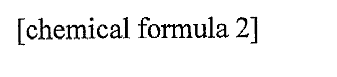 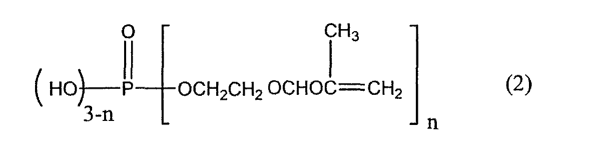 in which, n represents an integer of 1 to 3.

Generally, phosphate type (meth)acrylate is obtained as a reaction product of phosphoric anhydride and 2-hydroxyethyl (meth)acrylate. Phosphate type (meth)acrylate specifically includes mono(2-methacryloyloxyethyl)acid phosphate and di(2-methacryloyloxyethyl)acid phosphate. One of these is used alone, or two or more of these are used in combination.

Other than those described above, another material may be added to the adhesive component according to the purpose of use. For example, an adhesive aid, such as a coupling agent, an adhesiveness improving agent and a leveling agent, may be appropriately added to the adhesive component. Thus, further better adhesiveness and handling properties can be provided.

As the coupling agent, ketimine-, vinyl group-, acryl group-, amino group-, epoxy group- and isocyanate group-containing materials can be preferably used from the viewpoint of an improvement in adhesiveness. Specifically, silane coupling agents having acryl groups include (3-methacryloxypropyl)trimethoxysilane, (3-acryloxypropyl)trimethoxysilane, (3-methacryloxypropyl)dimethoxymethylsilane and (3-acryloxypropyl)dimethoxymethylsilane. Silane coupling agents having amino groups include N-β(aminoethyl)γ-aminopropyltrimethoxysilane, N-β(aminoethyl)γ-aminopropylmethyldimethoxysilane, γ-aminopropyltriethoxysilane, N-phenyl-γ-aminopropyltrimethoxysilane and the like. Silane coupling agents having ketimine include those obtained by reacting the above silane coupling agents having amino groups with ketone compounds such as acetone, methyl ethyl ketone and methyl isobutyl ketone. Also, silane coupling agents having epoxy groups include γ-glycidyloxypropyltrimethoxysilane, γ-glycidyloxypropyltriethoxysilane, γ-glycidyloxypropyl-methyldimethoxysilane, γ-glycidyloxypropyl-methyldiethoxysilane and the like.

The compounding proportion of the coupling agent is preferably 0.1 to 20 parts by mass, based on 100 parts by mass of the total of other compounds in the circuit connecting material. If the compounding proportion of the coupling agent is less than 0.1 part by mass, there is a tendency that no substantial effect of addition is obtained. Also, if the compounding proportion of the coupling agent is more than 20 parts by mass, there are tendencies that the film formability of an adhesive layer made of the circuit connecting material, in forming the adhesive layer on the supporting substrate, decreases, and that the film thickness strength decreases. However, from the viewpoint of effectively achieving the object of the present invention, preferably, the coupling agent is not one containing silicon, such as a silane coupling agent. When the coupling agent is a silane coupling agent, the compounding proportion of the silane coupling agent is 0.1% or less by mass, in terms of silicon atoms, based on the total amount of the adhesive component.

The adhesive component should be included in the circuit connecting material in the range of more than 0 and 100% or less by mass, from the viewpoint of achieving the object of the present invention.

Even if the circuit connecting material of the present invention contains no conductive particles, connection is obtained by the direct contact of the circuit electrodes which are opposed to each other during connection. However, the circuit connecting material preferably contains conductive particles because more stable connection between the circuit electrodes is obtained.

The conductive particles included as required in the present invention are not particularly limited as long as they are those having conductivity that can obtain electrical connection. The conductive particles include, for example, particles of metals such as Au, Ag, Ni, Cu and solder, and carbon. Also, the conductive particle may be one in which a core particle is covered with one layer or two or more layers and the outermost layer has conductivity. In this case, from the viewpoint of obtaining more excellent pot life, the outermost layer preferably comprises as the main component a precious metal such as Au, Ag, and/or a platinum group metal, rather than a transition metal such as Ni and Cu, and more preferably comprises at least one or more of these precious metals. Among these precious metals, Au is most preferred.

The conductive particle may be one obtained by further covering the surface of a particle, as a core, comprising a transition metal as the main component, or the surface of a layer covering the core and comprising a transition metal as the main component, with a layer comprising a precious metal as the main component. Also, the conductive particle may be one comprising as a core an insulating particle comprising non-conductive glass, ceramic or plastic, or the like, as the main component, with the surface of this core covered with a layer comprising the above metal or carbon as the main component.

When the conductive particle is one obtained by covering a core, which is an insulating particle, with a conductive layer or conductive layers, the insulating particle is preferably one comprising plastic as the main component, and the outermost layer is preferably one comprising a precious metal as the main component. Thus, the conductive particles in the circuit connecting material can be deformed well on heating and pressurization. Moreover, the contact area of the conductive particles with the circuit electrodes and the connection terminals increases during the connection of the circuits and the like. Therefore, the connection reliability of the circuit connecting material can be further improved. From a similar viewpoint, the conductive particle is preferably a particle comprising as the main component the above metal that is melted by heating.

When the conductive particle is one obtained by covering a core which is an insulating particle with a conductive layer or conductive layers, the thickness of the conductive layer is preferably 100 Å (10 nm) or more to obtain further better conductivity. Also, when the conductive particle is one obtained by further covering the surface of a particle, as a core, comprising a transition metal as the main component, or the surface of a layer covering the core and comprising a transition metal as the main component, with a layer comprising a precious metal as the main component, the thickness of the above layer comprising a precious metal as the main component, which is the outermost layer, is preferably 300 Å (30 nm) or more. If this thickness is less than 300 Å, the outermost layer is easily broken. As a result, the exposed transition metal comes into contact with the adhesive component, and free radicals are easily generated by the oxidation-reduction action by the transition metal, so that there is a tendency that the pot life decreases easily. On the other hand, if the thickness of the above conductive layer increases, their effect is saturated, so that the thickness is preferably 1 µm or less.

When the circuit connecting material contains the conductive particles, the compounding proportion of the conductive particles is not particularly limited, but it is preferably 0.1 to 30 parts by volume, based on 100 parts by volume of the adhesive component, and more preferably 0.1 to 10 parts by volume. If this value is less than 0.1 part by volume, there is a tendency that good conductivity is not easily obtained. If this value is more than 30 parts by volume, there is a tendency that a short in the circuit and the like occurs easily. The compounding proportion (parts by volume) of the conductive particles is determined based on the volume of each component at 23°C before the circuit connecting material is cured. The volume of each component can be obtained by a method in which weight is converted to volume using specific gravity, and a method in which the component is put into a container such as a graduated cylinder containing a suitable solvent (water, alcohol, or the like) that wets the component well without dissolving or swelling the component, and calculation is performed from the increased volume. Also, when the circuit connecting material is divided into two or more layers, a layer containing a radical polymerization initiator or an epoxy resin curing agent and a layer containing conductive particles, an improvement in pot life is obtained.

The circuit connecting material according to the present invention may contain rubber. Thus, the relaxation of stress and improvement in adhesiveness are possible. Further, a stabilizer can be added to this circuit connecting material for the control of the curing speed and to provide storage stability. Further, a filler, a softener, an accelerator, an antioxidant, a colorant, a flame retardant, a thixotropic agent, a phenolic resin, a melamine resin, isocyanates and the like may be compounded in the circuit connecting material.

The circuit connecting material preferably contains a filler because improvements in connection reliability and the like are obtained. As the filler, those having insulation properties, with their maximum diameter less than the average particle diameter of the conductive particles, can be used. The compounding proportion of the filler is preferably 5 to 60 parts by volume, based on 100 parts by volume of the adhesive component. If the compounding proportion of the filler is more than 60 parts by volume, there is a tendency that the effect of the reliability improvement is saturated. If the compounding proportion of the filler is less than 5 parts by volume, there is a tendency that the effect of adding the filler decreases.

When the circuit connecting material of the present invention is liquid at ordinary temperature, it can be used in a pasty state. When the circuit connecting material is solid at ordinary temperature, it may be turned into a paste using a solvent, in addition to being turned into a paste by heating. The solvent that can be used is not particularly limited as long as it does not react with the circuit connecting material and exhibits sufficient solubility. The solvent that can be used is preferably one having a boiling point of 50 to 150°C at ordinary pressure and includes, for example, the above-described organic solvents. If the boiling point is less than 50°C, the solvent volatilizes easily at room temperature, and there is a tendency that the workability, when a film described below is fabricated, worsens. Also, if the boiling point is more than 150°C, it is difficult to volatilize the solvent, and there is a tendency that sufficient adhesive strength is not obtained after adhesion. One solvent is used alone, or two or more solvents are used in combination.

Also, the circuit connecting material of the present invention can be used after being formed like a film. This film-like circuit connecting material can be obtained by coating a supporting substrate with a mixed solution in which a solvent and the like are added to the circuit connecting material, or impregnating a substrate, such as a nonwoven fabric, with the above mixed solution and placing the substrate on a supporting substrate, and then removing the solvent and the like. When the circuit connecting material is formed like a film in this manner, the circuit connecting material has excellent handling properties and is further convenient.

As the supporting substrate used, sheet-like or film-like ones are preferred. Also, the supporting substrate may be one having a shape in which two or more layers are laminated. The supporting substrate includes polyethylene terephthalate (PET) films, oriented polypropylene (OPP) films, polyethylene (PE) films and polyimide films. Among them, PET films are preferred from the viewpoint of an improvement in dimensional precision, and cost reduction.

The above-described circuit connecting material can also be used as a circuit connecting material for different types of adherends having different thermal expansion coefficients. Specifically, the above-described circuit connecting material can also be used as semiconductor device adhesive materials represented by CSP elastomers, CSP underfill materials, LOC tapes and the like, in addition to circuit connecting materials represented by anisotropic conductive adhesives, silver pastes, silver films, and the like.

### (Circuit Member Connection Structure)

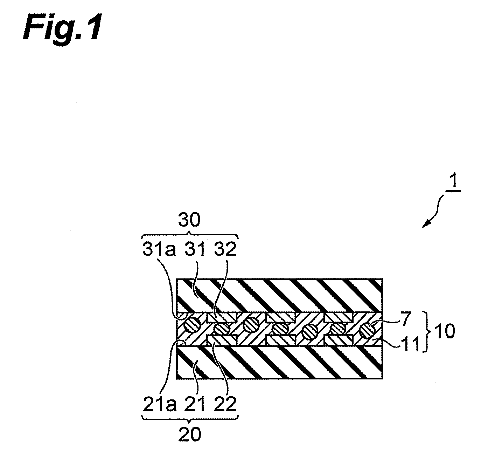

Figure 1 is a schematic cross-sectional view showing one embodiment of a circuit member connection structure according to the present invention. A circuit member connection structure 1 shown in Figure 1 comprises a first circuit member 20 and a second circuit member 30 opposed to each other, and a circuit connecting portion 10 connecting these is provided between the first circuit member 20 and the second circuit member 30.

The first circuit member 20 has a first circuit substrate 21, and first circuit electrodes 22 formed on a major surface 21a of the first circuit substrate 21. The second circuit member 30 has a second circuit substrate 31, and second circuit electrodes 32 formed on a major surface 31 a of the second circuit substrate 31. An insulating layer (not shown) may be optionally formed on the major surface 21a of the first circuit substrate 21, and/or on the major surface 31a of the second circuit substrate 31. In other words, the insulating layer is formed between at least one of the first circuit member 20 and the second circuit member 30, and the circuit connecting portion 10.

The first and second circuit substrates 21 and 31 include substrates made of inorganic substances such as semiconductor, glass and ceramic, organic substances such as polyimide substrates represented by TCPs, FPCs and COFs, polycarbonate, polyethylene terephthalate, polyethersulfone, epoxy resins and acrylic resins, and composite materials of these inorganic substances and organic substances. From the viewpoint of further increasing the adhesive strength to the circuit connecting portion 10, at least one of the first and second circuit substrates is preferably a substrate made of a material comprising at least one resin selected from the group consisting of polyethylene terephthalate, polyethersulfone, epoxy resins, acrylic resins, polyimide resins and glass.

Also, when the insulating layer is formed, the insulating layer is preferably a layer comprising at least one resin selected from the group consisting of silicone resins, acrylic resins and polyimide resins. Thus, the adhesive strength between the first circuit substrate 21 and/or the second circuit substrate 31 and the circuit connecting portion 10 is further improved, compared with those in which the above layer is not formed.

The surface of at least one of the first circuit electrodes 22 and the second circuit electrodes 32 is preferably made of a material comprising at least one selected from the group consisting of gold, silver, tin, platinum group metals and indium-tin oxide. Thus, it is possible to further reduce the resistance value between the opposed circuit electrodes 22 and 33 while maintaining the insulation between the circuit electrodes 22 or 32 neighboring on the same circuit member 20 or 30.

Specific examples of the first and second circuit members 20 and 30 include glass substrates or plastic substrates on which circuit electrodes are formed of ITO and the like, used in liquid crystal displays, as well as printed wiring boards, ceramic wiring boards, flexible wiring boards, semiconductor silicon chips and the like. These can be used in combination as required.

The circuit connecting portion 10 is formed of the cured product of the above circuit connecting material containing conductive particles. The circuit connecting portion 10 is composed of an insulating layer 11 and conductive particles 7 dispersed in the insulating layer 11. The conductive particles 7 in the circuit connecting portion 10 are located not only between the opposed first circuit electrodes 22 and second circuit electrodes 32 but also between the major surfaces 21a and 31a. In the circuit member connection structure 1, the conductive particles 7 are in direct contact with both of the first and second circuit electrodes 22 and 32. Thus, the first and second circuit electrodes 22 and 32 are electrically connected via the conductive particles 7. Therefore, the connection resistance between the first circuit electrodes 22 and the second circuit electrodes 32 is sufficiently reduced. Therefore, the current flow between the first and second circuit electrodes 22 and 32 can be smooth, and the function of the circuits can be sufficiently exhibited. When the circuit connecting portion 10 does not contain the conductive particles 7, the first circuit electrodes 22 and the second circuit electrodes 32 are electrically connected by direct contact with each other.

The circuit connecting portion 10 is composed of the cured product of the above circuit connecting material as described below, so that the adhesion of the circuit connecting portion 10 to the first circuit member 20 and the second circuit member 30 is sufficiently high.

### (Connection Method for Circuit Member Connection Structure)

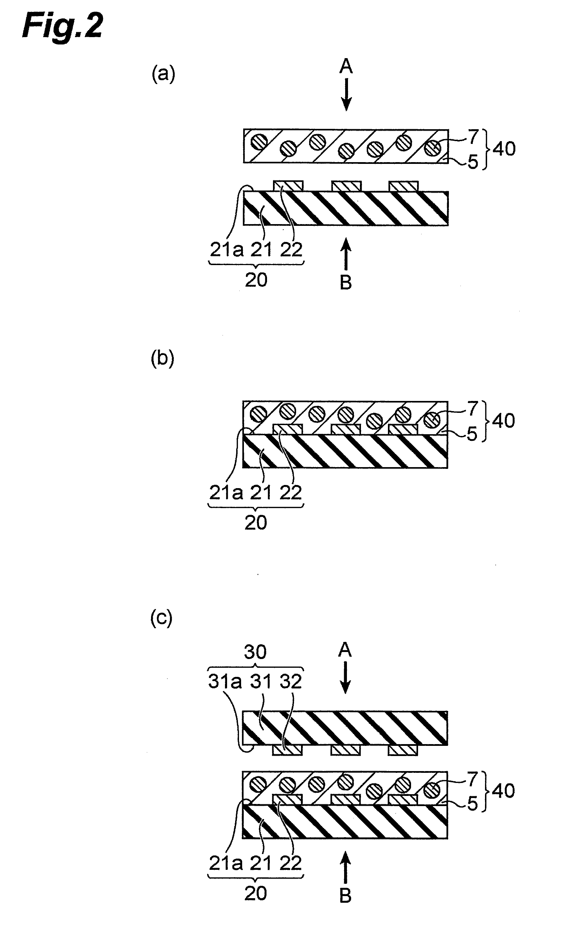

Figure 2 is a process diagram showing one embodiment of a method for connecting circuit members according to the present invention by a schematic cross-sectional view.

In this embodiment, first, the above-described first circuit member 20 and a film-like circuit connecting material 40 are prepared. The film-like circuit connecting material 40 comprises an adhesive component 5 containing a fluorine-containing organic compound, and the conductive particles 7.

A circuit connecting material not comprising the conductive particles 7 can also be used. In this case, the circuit connecting material is also called an NCP (Non-Conductive Paste). On the other hand, a circuit connecting material comprising the conductive particles 7 is also called an ACP (Anisotropic Conductive Paste).

The thickness of the circuit connecting material 40 is preferably 5 to 50 µm. If the thickness of the circuit connecting material 40 is less than 5 µm, there is a tendency that the circuit connecting material 40 insufficiently fills between the first and second circuit electrodes 22 and 32. On the other hand, if the thickness of the circuit connecting material 40 is more than 50 µm, there is a tendency that ensuring conduction between the first and second circuit electrodes 22 and 32 is difficult.

Next, the film-like circuit connecting material 40 is placed on a surface of the first circuit member 20 on which the circuit electrodes 22 are formed. Then, the film-like circuit connecting material 40 is pressurized in the directions of arrows A and B in Figure 2 (a) to temporarily connect the film-like circuit connecting material 40 to the first circuit member 20 (Figure 2 (b)).

The pressure at this time is not particularly limited as long as it is in a range in which the circuit member is not damaged, but it is generally preferably 0.1 to 30 MPa. Also, pressurization may be performed while heating, and the heating temperature is a temperature at which the circuit connecting material 40 is not substantially cured. The heating temperature is generally preferably 50 to 190°C. These heating and pressurization are preferably performed for a time in the range of 0.5 to 120 seconds.

Then, as shown in Figure 2 (c), the second circuit member 30 is placed on the film-like circuit connecting material 40, with the second circuit electrodes 32 facing the first circuit member 20 side. When the film-like circuit connecting material 40 is adhesively provided on a supporting substrate (not shown), the second circuit member 30 is placed on the film-like circuit connecting material 40 after the supporting substrate is peeled off. Then, while the circuit connecting material 40 is heated, the whole is pressurized in the directions of arrows A and B in Figure 2 (c). Also, the film-like circuit connecting material 40 comprises the circuit connecting material of the present invention, so that even if it is left, provided on the supporting substrate, it has sufficiently excellent transferability, with the change in transferability over time suppressed, and has sufficiently high adhesiveness to the circuit members.

The heating temperature is, for example, 90 to 200°C, and the connection time is, for example, 1 second to 10 minutes. These conditions are appropriately selected according to the application, circuit connecting material and circuit members used, and post-curing may be performed as required. For example, the heating temperature when the circuit connecting material contains a radically polymerizable compound, is a temperature at which a radical polymerization initiator can generate a radical. Thus, a radical is generated in the radical polymerization initiator, and the polymerization of the radically polymerizable compound is initiated.

By the heating of the film-like circuit connecting material 40, the film-like circuit connecting material 40 is cured, with the distance between the first circuit electrodes 22 and the second circuit electrodes 32 sufficiently decreased, so that the first circuit member 20 and the second circuit member 30 are firmly connected via the circuit connecting portion 10.

By the curing of the film-like circuit connecting material 40, the circuit connecting portion 10 is formed, so that the circuit member connection structure 1 as shown in Figure 1 is obtained. The connection conditions are appropriately selected according to the application, circuit connecting material and circuit members used.

According to this embodiment, it is possible to bring the conductive particles 7 into contact with both of the opposed first and second circuit electrodes 22 and 32 in the obtained circuit member connection structure 1, so that the connection resistance between the first and second circuit electrodes 22 and 32 can be sufficiently reduced. The circuit connecting portion 10 is composed of the cured product of the above circuit connecting material, so that the adhesion of the circuit connecting portion 10 to the first and second circuit members 20 or 30 is sufficiently high.

The preferred embodiments of the present invention have been described above, but the present invention is not limited to these.

### Examples

The present invention will be specifically described below based on examples, but the present invention is not limited to these.

### (Fabrication of Conductive Particles)

A layer of nickel having a thickness of 0.2 µm was provided on the surface of a polystyrene particle, and a layer of gold having a thickness of 0.04 µm was further provided on the surface of this layer of nickel. Thus, conductive particles having an average particle diameter of 10 µm were obtained.

### (Preparation of Polyester Urethane Resin)

Polyester polyol was obtained by the reaction of terephthalic acid as dicarboxylic acid and propylene glycol as diol. This polyester polyol was dissolved in methyl ethyl ketone (MEK) to obtain a solution. The obtained solution was put into a stainless steel autoclave with a heater comprising a stirrer, a thermometer, a condenser and a vacuum generating apparatus, and a nitrogen gas introduction pipe. Then, a predetermined amount of 4,4'-diphenylmethane diisocyanate as isocyanate was put into the above autoclave, and 0.02 part by mass of dibutyltin laurate as a catalyst, based on 100 parts by mass of polyester polyol, was put into the autoclave. The contents were allowed to react at 75°C for 10 hours and then cooled to 40°C. Further, piperazine was added to allow reaction to occur for 30 minutes for chain extension, and then, the solution was neutralized with triethylamine.

When the above solution after reaction was dropped into pure water, the solvent and the catalyst were dissolved in water, and a polyester urethane resin was precipitated. Then, the precipitated polyester urethane resin was dried by a vacuum dryer. When the weight molecular weight of the polyester urethane resin was measured by GPC analysis, it was 27000. In preparing the above polyester urethane resin, the compounding molar ratio of terephthalic acid/propylene glycol/4,4'-diphenylmethane diisocyanate was 1.0/1.3/0.25.

### (Preparation of Urethane Acrylate)

400 parts by mass of polycaprolactone diol having a weight average molecular weight of 800, 131 parts by mass of 2-hydroxypropyl acrylate, 0.5 part by mass of dibutyltin dilaurate as a catalyst and 1.0 part by mass of hydroquinone monomethyl ether as a polymerization inhibitor were stirred and mixed while being heated to 50°C. Then, 222 parts by mass of isophorone diisocyanate was dropped, and the temperature was increased to 80°C while the mixture was further stirred, to allow reaction for urethane to proceed. After it was confirmed that the reaction rate of the isocyanate groups was 99% or more, the temperature was decreased to obtain urethane acrylate.

### (Synthesis Example 1)

A 1000 mL separable flask comprising a Dean-Stark reflux condenser, a thermometer and a stirrer was prepared. 15.0 mmol of polyoxypropylenediamine and 105.0 mmol of 2,2-bis[4-(4-aminophenoxy)phenyl]hexafluoropropane as diamine compounds and 287 g of N-methyl-2-pyrrolidone (NMP) as an aprotic polar solvent were added into the separable flask and stirred at room temperature for 30 minutes. Then, 180 g of toluene as an aromatic hydrocarbon-based organic solvent that can undergo azeotropy with water and 114.0 mmol of 4,4'-hexafluoropropylidenebisphthalic dianhydride as tetracarboxylic dianhydride were added, the temperature was increased to 50°C, and the contents were stirred at the temperature for 1 hour. Then, the temperature was further increased to 160°C to allow reflux to occur for 3 hours. After it was confirmed that a theoretical amount of water accumulated in a water metering receiver and that no outflow of water was seen, water and toluene in the water metering receiver were removed, and the temperature was increased to 180°C to remove toluene in the reaction solution to obtain an NMP solution of a polyimide resin.

The above NMP solution of a polyimide resin was put into methanol, and the precipitate was recovered, then ground and dried to obtain a fluorine-containing polyimide resin 1 containing no silicon-containing compound. The weight average molecular weight of the obtained polyimide resin 1 was 112000. 40% by mass of the above polyimide resin 1 was dissolved in MEK.

### (Synthesis Example 2)

Operation similar to that of Synthesis Example 1 was performed except that the diamine compounds were changed to 17.8 mmol of bisaminopropyltetramethyldisiloxane and 124.7 mmol of 2,2-bis[4-(4-aminophenoxy)phenyl]hexafluoropropane, that the tetracarboxylic dianhydride was changed to 135.4 mmol of 4,4'-hexafluoropropylidenebisphthalic dianhydride, that the amount of NMP added was changed to 275 g, and that the amount of toluene added was changed to 175 g, to obtain a fluorine-containing polyimide resin 2. The silicon content in the fluorine-containing polyimide resin 2 was 0.8% by mass, and the weight average molecular weight of the obtained fluorine-containing polyimide resin 2 was 56000. 40% by mass of the above polyimide resin 2 was dissolved in MEK.

### (Synthesis Example 3)

Operation similar to that of Synthesis Example 1 was performed except that the diamine compounds were changed to 41.3 mmol of bisaminopropyltetramethyldisiloxane and 123.8 mmol of 2,2-bis[4-(4-aminophenoxy)phenyl]hexafluoropropane, that the tetracarboxylic dianhydride was changed to 156.8 mmol of 4,4'-hexafluoropropylidenebisphthalic dianhydride, that the amount of NMP added was changed to 306 g, and that the amount of toluene added was changed to 200 g, to obtain a fluorine-containing polyimide resin 3. The silicon content in the fluorine-containing polyimide resin 3 was 1.6% by mass, and the weight average molecular weight of the obtained fluorine-containing polyimide resin 3 was 74000. 40% by mass of the above polyimide resin 3 was dissolved in MEK.

### (Synthesis Example 4)

Operation similar to that of Synthesis Example 1 was performed except that the diamine compounds were changed to 7.8 mmol of bisaminopropyltetramethyldisiloxane and 134.7 mmol of polyoxypropylenediamine, that the tetracarboxylic dianhydride was changed to 135.4 mmol of 4,4'-propylidenebisphthalic dianhydride, that the amount of NMP added was changed to 275 g, and that the amount of toluene added was changed to 175 g, to obtain a non-fluorine-containing polyimide resin 4. The silicon content in the non-fluorine-containing polyimide resin 4 was 1.0% by mass, and the weight average molecular weight of the obtained non-fluorine-containing polyimide resin 4 was 98000. The above polyimide resin 4 was not dissolved in MEK.

The raw materials and properties of the above polyimide resins are collectively shown in Table 2.

**[Table 2]**

| | Synthesis Example 1 | Synthesis Example 2 | Synthesis Example 3 | Synthesis Example 4 |
|---|---|---|---|---|
| Diamine compounds | Polyoxypropylene diamine | Bisaminopropyl tetramethyldisiloxane | Bisaminopropyl tetramethyldisiloxane | Bisaminopropyl tetramethyldisiloxane |
| | 2,2-bis[4-(4-amino phenoxy)phenyl] hexafluoropropane | 2,2-bis[4-(4-amino phenoxy)phenyl] hexafluoropropane | 2,2-bis[4-(4-amino phenoxy)phenyl] hexafluoropropane | Polyoxypropylene diamine |
| Tetracarboxylic dianhydride | 4,4'-hexafluoro propylidene bisphthalic dianhydride | 4,4'-hexafluoro propylidene bisphthalic dianhydride | 4,4'-hexafluoro propylidene bisphthalic dianhydride | 4,4'-propylidene bisphthalic dianhydride |
| Silicon content (% by mass) | 0 | 0.8 | 1.6 | 1.0 |
| Weight average molecular weight | 112000 | 56000 | 74000 | 98000 |
| Solubility in MEK | soluble | soluble | soluble | insoluble |

### (Example 1)

25 parts by mass of an MEK solution of the fluorine-containing polyimide resin 1 (containing 10 parts by mass of the fluorine-containing polyimide resin 1), 40 parts by mass of the above polyester urethane resin, 49 parts by mass of the above urethane acrylate, 1 part by mass of di(2-methacryloyloxyethyl)acid phosphate as phosphate type acrylate and 5 parts by mass of t-hexyl peroxy2-ethylhexanonate were compounded. 3 parts by volume of the above-described conductive particles, based on 100 parts by volume of the adhesive component comprising the fluorine-containing polyimide resin 1, the polyester urethane resin, the urethane acrylate, the phosphate type acrylate and the t-hexyl peroxy2-ethylhexanonate, were compounded and dispersed in the obtained solution to obtain a circuit connecting material. Then, a PET film having a thickness of 80 µm and having one surface treated was coated with the obtained circuit connecting material, using a coating apparatus, to obtain a coating film. Next, the coating film was dried with hot air at 70°C for 10 minutes to obtain a film-like circuit connecting material having a thickness of 20 µm. The content proportion of the silicon-containing compound in this circuit connecting material was 0% by mass, in terms of silicon atoms, based on the total amount of the adhesive component.

### (Example 2)

A film-like circuit connecting material was obtained as in Example 1, except that the fluorine-containing polyimide resin 2 was used instead of the fluorine-containing polyimide resin 1. The content proportion of the silicon-containing compound in this circuit connecting material was 0.08% by mass, in terms of silicon atoms, based on the total amount of the adhesive component.

### (Comparative Example 1)

50 parts by mass of the above polyester urethane resin, 49 parts by mass of the above urethane acrylate, 1 part by mass of the above phosphate type acrylate and 5 parts by mass of t-hexyl peroxy2-ethylhexanonate were compounded. The conductive particles were compounded and dispersed in the compound to obtain a circuit connecting material. The conductive particles in the circuit connecting material were 3% by mass, based on the total amount of the circuit connecting material. Then, a PET film having a thickness of 80 µm and having one surface treated was coated with the obtained circuit connecting material, using a coating apparatus, to obtain a coating film. Next, the coating film was dried with hot air at 70°C for 10 minutes to obtain a film-like circuit connecting material having a thickness of 20 µm.

### (Comparative Example 2)

A film-like circuit connecting material was obtained as in Example 1, except that the fluorine-containing polyimide resin 3 was used instead of the fluorine-containing polyimide resin 1. The content proportion of the silicon-containing compound in this circuit connecting material was 0.15% by mass, in terms of silicon atoms, based on the total amount of the adhesive component.

### Comparative Example 3)

(The non-fluorine-containing polyimide resin 4 was used instead of the fluorine-containing polyimide resin 1 to attempt to fabricate a circuit connecting material, but the non-fluorine-containing polyimide resin 4 was not dissolved in MEK, so that a circuit connecting material could not be fabricated. The content proportion of the silicon-containing compound in this circuit connecting material was 0.10% by mass, in terms of silicon atoms, based on the total amount of the adhesive component.

### <Fabrication of Circuit Member Connection Structure>

A 3-layer flexible substrate 1 (FPC substrate 1), in which 500 copper circuit wires with a line width of 50 µm, a pitch of 100 µm and a thickness of 18 µm were formed on a polyimide film A (manufactured by Ube Industries, Ltd., trade name: "Upilex", thickness: 75 µm) via an adhesive layer, was prepared. Also, a 2-layer flexible substrate 2 (FPC substrate 2), in which 500 copper circuit wires with a line width of 50 µm, a pitch of 100 µm and a thickness of 8 µm were directly formed on a polyimide film B (manufactured by Ube Industries, Ltd., trade name: "Upilex", thickness: 25 µm), was prepared. Further, a glass substrate, in which 500 chromium circuit wires with a line width of 50 µm, a pitch of 100 µm, and a thickness of 0.4 µm were directly formed on glass (manufactured by Corning Incorporated, trade name: "#1737"), was prepared.

Then, the film-like circuit connecting material obtained as described above was located between each of the above FPC substrates and the glass substrate. Then, 10 seconds of heating and pressurization were performed in the direction of their lamination, under conditions of 160°C and 3 MPa, using a thermocompression bonding apparatus (heating mode: constant heating type, manufactured by Toray Engineering Co., Ltd.). Thus, a circuit member connection structure, in which the FPC substrate and the glass substrate were electrically connected by the cured product of the circuit connecting material over a width of 2 mm, was fabricated.

### <Measurement of Peel Force>

In the fabrication of the above circuit member connection structure, the adhesive surface of the film-like circuit connecting material was previously bonded onto the glass substrate, then, they were heated and pressurized at 70°C at 0.5 MPa for 5 seconds to be temporarily connected, subsequently, the PET film was peeled off, and the film-like circuit connecting material was connected to the FPC substrate. At the time, the peel force of the PET film from the film-like circuit connecting material was measured by a 90° peeling method according to JIS-Z0237. As the peel force measuring apparatus, Tensilon UTM-4 (peel speed: 50 mm/min, 25°C, manufactured by Toyo Baldwin) was used. Also, the obtained film-like circuit connecting material was housed in a vacuum package and left at 40°C for 5 days, then, a circuit member connection structure was fabricated as in the above, and the peel force at the time of peeling the PET film was measured. The results are shown in Table 3.

### <Measurement of Adhesive Strength>

The adhesive strength between the circuits in the obtained circuit member connection structure was measured by the 90-degree peeling method according to JIS-Z0237 and evaluated. Here, as the adhesive strength measuring apparatus, Tensilon UTM-4 (peel speed: 50 mm/min, 25°C, manufactured by Toyo Baldwin) was used. The results are shown in Table 3.

**[Table 3]**

| | FPC substrate 1 | | | | FPC substrate 2 | | | |
|---|---|---|---|---|---|---|---|---|
| | initial stage | | after 5 days at 40°C | | initial stage | | after 5 days at 40°C | |
| | peel force (N/2.5mm) | adhesive strength (N/cm) | peel force (N/2.5mm) | adhesive strength (N/cm) | peel force (N/2.5mm) | adhesive strength (N/cm) | peel force (N/2.5mm) | adhesive strength (N/cm) |
| Example 1 | 0.01 | 12.5 | 0.01 | 11.8 | 0.01 | 9.4 | 0.01 | 10.1 |
| Example 2 | 0.02 | 13.7 | 0.03 | 13.8 | 0.02 | 11.1 | 0.03 | 11.4 |
| Comparative Example 1 | 0.01 | 10.1 | 0.01 | 11.2 | 0.01 | 6.2 | 0.01 | 5.8 |
| Comparative Example 2 | 0.02 | 11.3 | - | - | 0.02 | 8.3 | - | - |
| Comparative Example 3 | impossible to fabricate | | | | | | | |

Any of the film-like circuit connecting materials obtained in Examples 1 and 2 and Comparative Examples 1 and 2 initially exhibited an adhesive strength of 6 N/cm or more, which is in the range that is practically no problem. However, the film-like circuit connecting material obtained in Example 1 contained the fluorine-containing polyimide resin, so that it exhibited a higher adhesive strength value than Example 1 and the comparative examples. Also, in the film-like circuit connecting material obtained in Example 2, the polyimide resin further had a silicone structure in addition to a fluorine atom, so that it exhibited higher adhesive strength than the comparative examples. On the other hand, the film-like circuit connecting material obtained in Comparative Example 2 had a high silicon content, so that after it was left at 40°C for 5 days, it changed over time, and the PET film could not be peeled off.

### <Observation of Connection Appearance>

The obtained circuit member connection structure was left in a high-temperature and high-humidity test apparatus at 85°C and a relative humidity of 85%RH for 250 hours to perform a humidity resistance test. Appearance immediately after adhesion and after the humidity resistance test was observed on the glass substrate side by a microscope. When peeling occurred between the circuit connecting portion and the interface of the space between the circuits, this was determined as NG because the insulation between the circuits decreased significantly. Also, the obtained film-like circuit connecting material was housed in a vacuum package and left at 40°C for 5 days, then, a circuit member connection structure was fabricated as in the above, and the appearance was similarly observed. The results are shown in Table 4.

**[Table 4]**

| | FPC substrate 1 | | | | FPC substrate 2 | | | |
|---|---|---|---|---|---|---|---|---|
| | initial stage | | after 5 days at 40°C | | initial stage | | after 5 days at 40°C | |
| | immediately after adhesion | after humidity resistance test | immediately after adhesion | after humidity resistance test | immediately after adhesion | after humidity resistance test | immediately after adhesion | after humidity resistance test |
| Example 1 | good | good | good | good | good | good | good | good |
| Example 2 | good | good | good | good | good | good | good | good |
| Comparative Example 1 | good | peeling occurred | good | peeling occurred | good | peeling occurred | good | peeling occurred |
| Comparative Example 2 | good | good | - | - | good | good | - | - |
| Comparative Example 3 | unmeasurable | | | | | | | |

When the film-like circuit connecting materials obtained in Examples 1 and 2 were used, no peeling occurred before and after the humidity resistance test, and they had good appearance. On the other hand, when the film-like circuit connecting material obtained in Comparative Example 1 was used, peeling occurred after the humidity resistance test because the adhesion between the circuit connecting portion and the glass substrate was weak.

The film-like circuit connecting materials obtained in Examples 1 and 2 exhibited good properties in all of the above evaluation. On the other hand, the film-like circuit connecting material obtained in Comparative Example 1 contained no fluorine-containing polyimide resin, so that peeling bubbles were generated in the circuit connecting portion and the glass substrate interface after the humidity resistance test. Also, the film-like circuit connecting material obtained in Comparative Example 2 had good initial properties. However, the silicon content was more than 0.10% by mass, so that after treatment at 40°C for 5 days, the tack to the PET film increased, and the PET film could not be peeled off from the circuit connecting material, therefore, it was impossible to fabricate a connection body. Further, in Comparative Example 3, the polyimide resin 4 fabricated in Synthesis Example 4 contained no fluorine, so that it had poor solubility, and a circuit connecting material could not be fabricated.

It is considered that the main factor of the effect of the present invention is an improvement in the wettability of the adhesive component on the adherend, and that this is due to the fact that the wettability of the adhesive component on the adherend is dramatically improved by the introduction of fluorine. Therefore, it is considered that similar effect is also obtained in circuit connecting materials comprising adhesive components containing not only fluorine-containing polyimide but other fluorine-containing organic compounds.

### Industrial Applicability

According to the present invention, it is possible to provide a circuit connecting material that exhibits sufficiently good adhesive strength, without depending on the materials of the circuit members, and has sufficiently excellent transferability, with the change in transferability over time suppressed, a circuit member connection structure using the same and a method for manufacturing a circuit member connection structure.

## Claims

1. A circuit connecting material for electrically connecting a first circuit member having a first circuit electrode formed on a major surface of a first circuit substrate, and a second circuit member having a second circuit electrode formed on a major surface of a second circuit substrate, with the first and the second circuit electrodes opposed to each other, comprising
an adhesive component containing a fluorine-containing organic compound,
wherein the adhesive component contains 0.10% or less by mass of a silicon-containing compound, in terms of silicon atoms, based on a total amount of the adhesive component.

2. A circuit connecting material for electrically connecting a first circuit member having a first circuit electrode formed on a major surface of a first circuit substrate, and a second circuit member having a second circuit electrode formed on a major surface of a second circuit substrate, with the first and the second circuit electrodes opposed to each other, comprising
an adhesive component containing a fluorine-containing organic compound,
wherein the adhesive component contains no silicon-containing compound.

3. The circuit connecting material according to claim 1 or 2,
wherein the fluorine-containing organic compound has a silicone structure.

4. The circuit connecting material according to any one of claims 1 to 3, wherein the adhesive component further contains a radical polymerization initiator, and wherein the fluorine-containing organic compound contains a radically polymerizable fluorine-containing organic compound.

5. The circuit connecting material according to any one of claims 1 to 3, wherein the fluorine-containing organic compound contains a fluorine-containing polyimide resin.

6. The circuit connecting material according to any one of claims 1 to 5, wherein the adhesive component further contains phosphate type (meth)acrylate.

7. The circuit connecting material according to any one of claims 1 to 3, wherein the adhesive component further contains an epoxy resin curing agent, and wherein the fluorine-containing organic compound contains a fluorine-containing epoxy resin.

8. The circuit connecting material according to any one of claims 1 to 7, wherein a weight average molecular weight of the fluorine-containing organic compound is 5000 or more.

9. The circuit connecting material according to any one of claims 1 to 8, wherein the fluorine-containing organic compound is soluble in an organic solvent.

10. The circuit connecting material according to any one of claims 1 to 9, wherein the fluorine-containing organic compound has an aromatic group and/or an alicyclic group.

11. The circuit connecting material according to any one of claims 1 to 10, wherein a glass transition temperature of the fluorine-containing organic compound is 50°C or more.

12. The circuit connecting material according to any one of claims 1 to 11, further comprising conductive particles.

13. A circuit member connection structure comprising:
a first circuit member having a first circuit electrode formed on a major surface of a first circuit substrate;
a second circuit member having a second circuit electrode formed on a major surface of a second circuit substrate and being located so that the second circuit electrode is located opposed to the first circuit electrode; and
a circuit connecting portion provided between the first circuit substrate and the second circuit substrate and connecting the first circuit member and the second circuit member so that the first and the second circuit electrodes are electrically connected,
wherein the circuit connecting portion is a cured product of the circuit connecting material according to any one of claims 1 to 12.

14. The circuit member connection structure according to claim 13, wherein a surface of at least one of the first and the second circuit electrodes is made of a material comprising at least one selected from the group consisting of gold, silver, tin, platinum group metals and indium-tin oxide.

15. The circuit member connection structure according to claim 13 or 14, wherein at least one of the first and the second circuit substrates is a substrate made of a material comprising at least one resin selected from the group consisting of polyethylene terephthalate, polyethersulfone, epoxy resins, acrylic resins, polyimide resins and glass.

16. The circuit member connection structure according to any one of claims 13 to 15, wherein a layer comprising at least one resin selected from the group consisting of silicone resins, acrylic resins and polyimide resins is formed between at least one of the first and the second circuit members and the circuit connecting portion.

17. A method for manufacturing a circuit member connection structure, comprising the steps of arranging a first circuit member having a first circuit electrode formed on a major surface of a first circuit substrate and a second circuit member having a second circuit electrode formed on a major surface of a second circuit substrate so that the first circuit electrode and the second circuit electrode are located opposed to each other, heating and pressurizing a laminate formed by interposing the circuit connecting material according to any one of claims 1 to 12 between the first circuit member and the second circuit member in a direction of its lamination, and connecting the first circuit member and the second circuit member so that the first and the second circuit electrodes are electrically connected.
